(19) Europäisches Patentamt
European Patent Office
Office européen des brevets

(11) EP 3 076 549 A1

(12) EUROPEAN PATENT APPLICATION
published in accordance with Art. 153(4) EPC

(43) Date of publication:
05.10.2016 Bulletin 2016/40

(51) Int Cl.:
H03K 17/00 (2006.01)　　　H03K 17/687 (2006.01)

(21) Application number: 13898161.8

(22) Date of filing: 26.11.2013

(86) International application number:
PCT/JP2013/081774

(87) International publication number:
WO 2015/079492 (04.06.2015 Gazette 2015/22)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(71) Applicant: Sanken Electric Co., Ltd.
Niiza-shi, Saitama 352-8666 (JP)

(72) Inventors:
• PARK, Hyo-jeong
Niiza-shi
Saitama 352-8666 (JP)

• TAJIMA, Kazunao
Niiza-shi
Saitama 352-8666 (JP)
• KURIHARA, Masahira
Niiza-shi
Saitama 352-8666 (JP)

(74) Representative: Grünecker Patent- und
Rechtsanwälte
PartG mbB
Leopoldstraße 4
80802 München (DE)

(54) **GATE DRIVE CIRCUIT AND INTELLIGENT POWER MODULE**

(57) A gate drive circuit of the invention includes: a drive unit (10) connected to a gate of a switching element (S1) and configured to drive the switching element (S1), characterized by: an abnormality detection unit (20) configured to supply a constant current to a control terminal of the switching element (S1), and to detect an abnormality of the switching element (S1) based on a transient change in voltage at the control terminal of the switching element (S1).

FIG. 1

EP 3 076 549 A1

**Description**

TECHNICAL FIELD

The present invention relates to a gate drive circuit, which drives a gate of a switching element used in an inverter and the like, and to an intelligent power module.

BACKGROUND ART

Patent Document 1 and Patent Document 2 have been known as conventional gate drive circuits. A gate drive circuit described in Patent Document 1 compares an absolute value of a gate potential of an IGBT (insulate gate bipolar transistor), which is a switching element, with an emitter potential thereof, and detects an abnormality when the gate potential and the emitter potential coincide with each other.

If an abnormality occurs in one of two IGBTs, such an abnormality is detected by means of an exclusive-OR element. The other IGBT which is different from the IGBT in which the abnormality has occurred is kept from being turned on. Thus, latch-up can be prevented from occurring in the normal IGBT.

A gate drive circuit described in Patent Document 2 includes a gate voltage control circuit on error detection, which detects a state of error based on a collector voltage of a switching element, and gradually reduces a gate voltage in response to a detected error signal.

In addition, there is also provided a protected operation retention circuit which retains the gate voltage reduction process even when a gate voltage off signal is inputted in the middle of the gate voltage reduction process on the error detection. This makes it possible to avoid a rapid drop in drive voltage of the switching element, and thus to prevent the switching element from being destroyed.

PRIOR ART DOCUMENTS

PATENT DOCUMENTS

Patent Document 1: Japanese Patent Application Publication No. Hei 2-79621
Patent Document 2: Japanese Patent Application Publication No. Hei 7-298602

SUMMARY OF THE INVENTION

PROBLEMS TO BE SOLVED BY THE INVENTION

However, the techniques of Patent Documents 1 and 2 cannot detect an open state between the gate of each IGBT and the gate drive circuit. Moreover, although the techniques of Patent Documents 1 and 2 can detect a state of short circuit of the gate of each IGBT, these techniques involve complicated circuit configurations.

An object of the present invention is to provide a gate drive circuit and an intelligent power module, which are capable of detecting an abnormality of an IGBT such as an open gate or a short circuit with a simple circuit configuration.

MEANS FOR SOLVING THE PROBLEMS

To solve the above-mentioned problems, the present invention is a gate drive circuit including a drive unit connected to a gate of a switching element and configured to drive the switching element, characterized by: an abnormality detection unit configured to supply a constant current to a control terminal of the switching element, and to detect an abnormality of the switching element based on a transient change in voltage at the control terminal of the switching element.

EFFECTS OF THE INVENTION

According to the gate drive circuit of the present invention, the abnormality detection unit detects an abnormality of an IGBT based on a change in voltage at a gate of the IGBT. Thus, it is possible to provide a gate drive circuit which is capable of detecting an abnormality of an IGBT such as an open gate or a short circuit with a simple circuit configuration.

BRIEF DESCRIPTION OF THE DRAWINGS

[Fig. 1] Fig. 1 is a circuit configuration diagram of a gate drive circuit of a first embodiment.
[Fig. 2] Fig. 2 is a timing chart showing operation waveforms of units in the gate drive circuit of the first embodiment.
[Fig. 3] Fig. 3 is a diagram showing a configuration of an intelligent power module including the gate drive circuits of the first embodiment.
[Fig. 4] Fig. 4 is a circuit configuration diagram of a gate drive circuit of a second embodiment.
[Fig. 5] Fig. 5 is a graph showing a change in gate voltage when a current is supplied from a constant current circuit to a gate of an IGBT.

MODES FOR CARRYING OUT THE INVENTION

Embodiments of a gate drive circuit and an intelligent power module of the present invention will be described below in detail with reference to the drawings.

(First Embodiment)

In the related art, an abnormality of a switching element is detected by using a collector voltage and an emitter voltage of a switching element. On the other hand, a gate drive circuit of a first embodiment is characterized in that the gate drive circuit detects whether or not a gate of an IGBT is open or short-circuited with a simple circuit configuration.

Specifically, the gate drive circuit of the first embodiment feeds a constant current to a gate terminal of the IGBT, and detects whether the gate of the IGBT is open or short-circuited based on a transient change in gate voltage due to capacitance of a capacitor in the IGBT. Specifically, the gate drive circuit uses the following formula.

[Formula 1]

$$V = \frac{i}{c} \int dt$$

(where V= voltage, i= current, c= capacitance, and t= time).

Thus, the gate drive circuit detects whether the gate of the IGBT is open or short-circuited based on an inclination of a gate voltage VOUT by a change in capacitance of the capacitor. When the gate of the IGBT is in an open state and the capacitance c is equal to zero, the voltage V becomes infinite whereby the gate voltage VOUT rises steeply.

On the other hand, when the gate of the IGBT is in a short-circuited state and the capacitance c is infinite, the voltage V becomes equal to zero whereby the gate voltage VOUT rises very little. When the gate of the IGBT is in a normal state and the capacitance c is normal, the gate voltage VOUT transiently represents an intermediate potential between zero and infinity due to capacitance coupling. At this time, the gate voltage VOUT is monitored and then the monitored gate voltage VOUT is compared with reference voltages V1 and V2, thereby constantly determining whether or not the gate of the IGBT is open or short-circuited. Further, a latch voltage is set at a prescribed timing by use of a detection timing, thereby detecting an error.

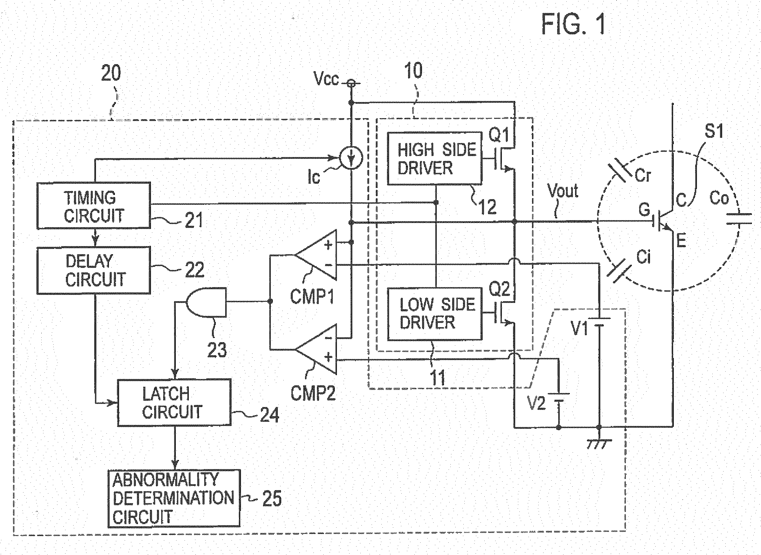

Next, the gate drive circuit of the first embodiment configured to detect whether the gate of the IGBT is open or short-circuited will be described with reference to Fig. 1.

The gate drive circuit includes: an IGBT S1 formed from a switching element; a drive unit 10 connected to a gate (a control terminal) of the IGBT S1 and configured to drive the IGBT S1; and a gate abnormality detection unit 20 configured to apply a constant current to the gate of the IGBT S1 and to detect an abnormality of the IGBT S1 based on a transient change in gate voltage of the IGBT S1. Specifically, the gate abnormality detection unit 20 determines whether or not the gate of the IGBT S1 is open or short-circuited based on the transient change in gate voltage of the IGBT S1.

The IGBT S1 includes a parasitic capacitance Cr between its collector and the gate, a parasitic capacitance Co between the collector and its emitter, and a parasitic capacitance Ci between the gate and the emitter. A series circuit of a switching element Q1 and a switching element Q2 each formed from an N-type MOSFET is connected between a power supply Vcc and the ground. A junction of the switching element Q1 and the switching element Q2 is connected to the gate of the IGBT S1.

The drive unit 10 includes a low side driver 11 which turns the switching element Q2 on and off, and a high side driver 12 which turns the switching element Q1 on and off. The switching element Q1 and the switching element Q2 are turned on and off alternately.

Meanwhile, an end of a constant current circuit Ic is connected to the power supply Vcc while another end of the constant current circuit Ic is connected to a non-inverting input terminal (+) of a comparator CMP1, an inverting input terminal (-) of a comparator CMP2, and the gate of the IGBT S1.

An inverting input terminal (-) of the comparator CMP1 is connected to a positive electrode of a direct-current power supply V1. A non-inverting input terminal (+) of the comparator CMP2 is connected to the positive electrode of the direct-current power supply V1.

When the constant current circuit Ic supplies the constant current to the gate of the IGBT S1, the comparator (a first comparator) CMP1 compares a voltage (a first reference voltage) of the direct-current power supply V1 with a voltage at the gate of the IGBT S1.

When the constant current circuit Ic supplies the constant current to the gate of the IGBT S1, the comparator (a second comparator) CMP2 compares a voltage (a second reference voltage) of a direct-current power er supply V2, which exceeds the voltage (the first reference voltage) of the direct-current power supply V1, with the voltage at the gate of the IGBT S1.

An output terminal of the comparator CMP1 and an output terminal of the comparator CMP2 are connected to an input terminal of an AND circuit 23. An output terminal of the AND circuit 23 is connected to a latch circuit 24.

A timing circuit 21 outputs a timing signal, which is synchronous with drive signals of the high side driver 12 and the low side driver 11, to the constant current circuit Ic and a delay circuit 22.

In response to the timing signal from the timing circuit 21, the constant current circuit Ic supplies the constant current to the gate of the IGBT S1 when the IGBT S1 is off (particularly when the switching elements Q1 and Q2 are off). The constant current circuit Ic outputs the constant current over a prescribed period shorter than an off period of the IGBT S1. A current value of the constant current is smaller than a value of a current to be supplied to the gate when driving the IGBT S1.

The delay circuit 22 delays the timing signal from the timing circuit 21 for a prescribed period and outputs a delay signal to the latch circuit 24. The latch circuit 24 latches an output from the AND circuit 23 based on the delay signal from the delay circuit 22, and outputs a signal to an abnormality determination circuit 25. Based on the signal from the latch circuit 24, the abnormality determination circuit (a determination circuit) 25 determines whether or not the state of the gate of the IGBT S1 is normal or abnormal.

Specifically, the abnormality determination circuit 25 determines whether or not the state of the gate of the IGBT S1 is normal or abnormal based on an output from the comparator CMP1 and an output from the comparator CMP2, after a lapse of a prescribed period from the point when the constant current circuit Ic supplies the constant current to the gate of the IGBT S1.

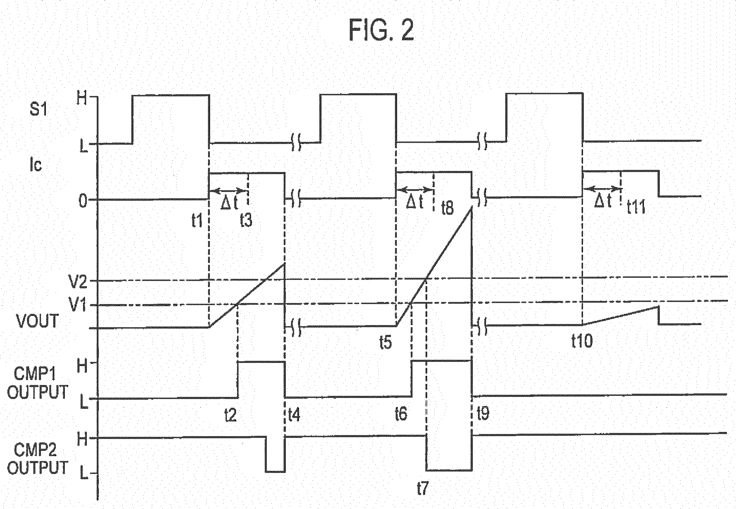

Next, operations of the gate drive circuit of the first embodiment thus configured will be described with reference to a timing chart shown in Fig. 2. For the convenience of description of the operations, the timing chart shown in Fig. 2 illustrates both of a case where the state of the gate of the IGBT S1 is normal and a case where the state thereof is abnormal.

Here, in Fig. 2, S1 denotes a gate signal of the IGBT, Ic denotes the constant current from the constant current circuit Ic, VOUT denotes the gate voltage of the IGBT, CMP1 OUTPUT denotes the output from the comparator CMP1, and CMP2 OUTPUT denotes the output from the comparator CMP2.

First, at time t1, the constant current circuit Ic supplies the constant current to the gate of the IGBT S1 in response to the timing signal from the timing circuit 21, and the gate voltage VOUT of the IGBT S1 starts increasing linearly.

When the gate voltage VOUT reaches a voltage V1 at time t2, the comparator CMP1 outputs H level to the AND circuit 23.

Next, at time t3 delayed by a prescribed period Δt from the time t1, the gate voltage VOUT becomes a voltage in a range from the voltage V1 to a voltage V2. For this reason, the comparator CMP2 outputs H level to the AND circuit 23.

The AND circuit 23 performs AND operation of H level from the comparator CMP1 and H level from the comparator CMP2. The latch circuit 24 is formed from a flip-flop circuit and the like. The latch circuit 24 latches H level from the AND circuit 23 based on the delay signal from the delay circuit 22, at the time t3 delayed by the prescribed period Δt from the time t1. Based on H level from the latch circuit 24, the abnormality determination circuit 25 determines that the state of the gate of the IGBT S1 is normal.

Next, at time t5, the constant current circuit Ic supplies the constant current to the gate of the IGBT S1 in response to the timing signal from the timing circuit 21, and the gate voltage VOUT of the IGBT S1 starts increasing linearly.

When the gate voltage VOUT reaches the voltage V1 at time t6, the comparator CAMP1 outputs H level to the AND circuit 23. When the gate voltage VOUT reaches the voltage V2 at time t7, the comparator CMP2 outputs L level to the AND circuit 23.

Next, at time t8 delayed by the prescribed period Δt from the time t5, the gate voltage VOUT becomes a voltage equal to or above the voltage V2. For this reason, the comparator CMP2 outputs L level to the AND circuit 23.

The AND circuit 23 outputs L level to the latch circuit 24. The latch circuit 24 latches L level from the AND circuit 23 based on the delay signal from the delay circuit 22, at the time t8 delayed by the prescribed period Δt from the time t5. Based on L level from the latch circuit 24, the abnormality determination circuit 25 determines that the state of the gate of the IGBT S1 is abnormal.

Next, at time t10, the constant current circuit Ic supplies the constant current to the gate of the IGBT S1 in response to the timing signal from the timing circuit 21, and the gate voltage VOUT of the IGBT S1 starts increasing linearly.

However, the gate voltage VOUT does not reach the voltage V1 at time t11 delayed by the prescribed period Δt from the time t10. For this reason, the comparator CMP1 outputs L level to the AND circuit 23. The comparator CMP2 outputs H level to the AND circuit 23.

The AND circuit 23 outputs L level to the latch circuit 24. The latch circuit 24 latches L level from the AND circuit 23 based on the delay signal from the delay circuit 22, at the time t11 delayed by the prescribed period Δt from the time t10. Based on L level from the latch circuit 24, the abnormality determination circuit 25 determines that the state of the gate of the IGBT S1 is abnormal.

As described above, according to the gate drive circuit of the first embodiment, the gate abnormality detection unit 20 detects the abnormality of the IGBT S1 based on the change in voltage at the gate of the IGBT S1. Thus, the gate drive circuit can detect the abnormality of the IGBT S1 such as an open gate or a short circuit with a simple circuit configuration.

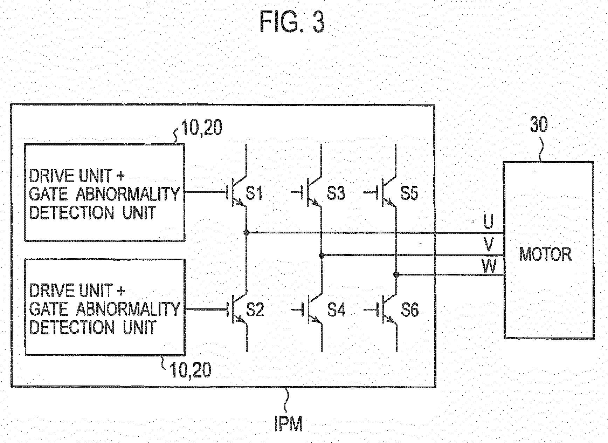

Fig. 3 is a diagram showing a configuration of an IPM (intelligent power module) including the gate drive circuits of the first embodiment. This IPM drives a three-phase motor 30. The IPM includes: U-phase IGBTs S1 and S2 connected in series; V-phase IGBTs S3 and S4 connected in series; W-phase IGBTs S5 and S6 connected in series; and the drive units 10 and the gate abnormality detection units 20 provided to the respective IGBTs.

A junction of the IGBT S1 and the IGBT S2 for the U phase is connected to a U-phase terminal of the motor 30. A junction of the IGBT S3 and the IGBT S4 for the V phase is connected to a V-phase terminal of the motor 30. A junction of the IGBT S5 and the IGBT S6 for the W phase is connected to a W-phase terminal of the motor 30.

(Second Embodiment)

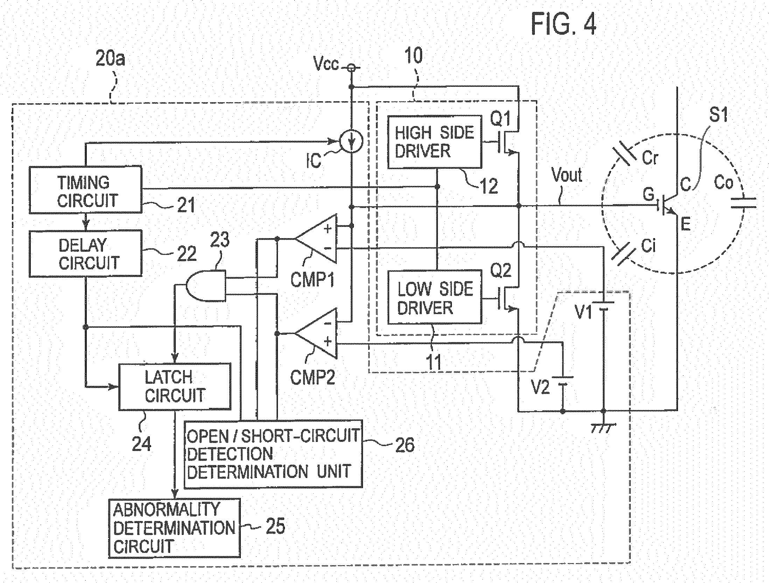

Fig. 4 is a circuit configuration diagram of a gate drive circuit of a second embodiment. The gate drive circuit of the second embodiment of Fig. 4 is characterized in that the gate drive circuit includes a gate abnormality detection unit 20a, in which an open/short-circuit detection determination circuit (a determination circuit) 26 is further provided to the gate abnormality detection unit 20 of the gate drive circuit of the first embodiment shown in Fig. 1.

The open/short-circuit detection determination circuit 26 is connected to an output of the delay circuit 22, an output of the comparator CMP1, and an output of the comparator CMP2. After a lapse of a prescribed period from the point when the constant current circuit Ic supplies the constant current to the gate of the IGBT S1, the open/short-circuit detection determination circuit 26 determines whether the IGBT S1 is open or short-circuited based on the output from the comparator CMP1 and the output from the comparator CMP2. Here, a latch circuit may be provided between the open/short-circuit detection determination circuit 26 and the output of each circuit.

Specifically, when the comparator CMP1 outputs H level and the comparator CMP2 outputs L level, the open/short-circuit detection determination circuit 26 determines that the IGBT S1 has an open abnormality.

When the comparator CMP1 outputs L level and the comparator. CMP2 outputs H level, the open/short-circuit detection determination circuit 26 determines that the IGBT S1 has a short-circuit abnormality.

The gate drive circuit according to the second embodiment is capable of not only determining whether the IGBT S1 is normal or abnormal, but also determining whether the IGBT S1 is open or short-circuited when the IGBT S1 is abnormal.

Here, detection or determination of the abnormality of the gate seems to be also possible in the case of supplying the current to the gate of the IGBT S1 via the switching element Q1, for example, which drives the IGBT S1. However, such a method of detection and determination has the following problems when the abnormality of the gate of the IGBT S1 is detected during an ON operation of the IGBT S1.

Specifically, a large current (about several amperes) is supplied to the gate of the IGBT S1 and the gate voltage rises steeply. Moreover, since the current is supplied from a voltage supply, the rise of the gate voltage does not become linear due to an influence of CR components, namely, gate capacitance and gate resistance of a current path, whereby detection accuracy is deteriorated. Furthermore, the detection accuracy is deteriorated by a variation in inclination of the rise of the gate voltage.

In this case, the following advantages can be achieved by providing the constant current circuit Ic (with a current smaller by two to three digits than that at the time of the ON operation of the IGBT S1) such as the gate drive circuit of the first embodiment or the gate drive circuit of the second embodiment. For example, by setting the current smaller by two to three digits (in the order of several milliamperes) than that applied during the drive, it is possible to delay the rise of the gate voltage and to freely adjust the inclination of the rise of the gate voltage. Moreover, since a constant current supply is provided, the inclination of the rise of the gate voltage is less susceptible to the CR components, and becomes linear and less variable. Thus, the detection accuracy can be improved.

It is to be noted that the present invention is not limited to the gate drive circuit of the first embodiment and the gate drive circuit of the second embodiment. For example, the abnormality determination circuit 25 may detect an abnormality of the IGBT S1 by changing the voltages of the direct-current power supplies V1 and V2, with a lapse of time T from the start of supply of the constant current by the constant current, circuit Ic.

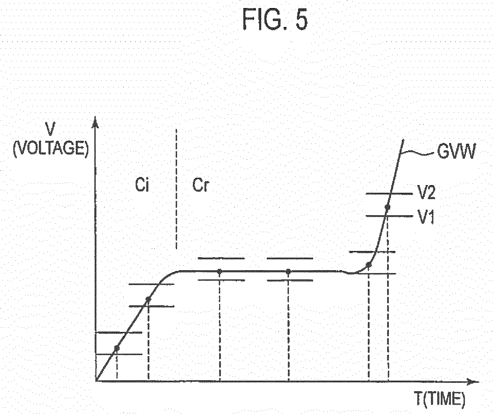

Fig. 5 is a graph showing a change in gate voltage when the current is supplied from the constant current circuit Ic to the gate of the IGBT S1. The gate voltage rises immediately after the start of the supply of the constant current, due to charge of the parasitic capacitance Ci. Thereafter, the gate voltage is changed by charge of the parasitic capacitance Cr. Hence, an abnormality at the gate can be detected by changing the voltages of the direct-current power supplies V1 and V2 in conformity to the change of the gate voltage. In addition, it is also possible to accurately detect a location of the abnormality. In the meantime, the constant current circuit Ic is preferably configured to output the constant current periodically. Meanwhile, it is also possible to omit the latch circuit 24.

INDUSTRIAL APPLICABILITY

The present invention is applicable to an inverter and the like.

EXPLANATION OF REFERENCE NUMERALS

| | |
|---|---|
| 10 | drive unit |
| 11 | low side driver |
| 12 | high side driver |
| 20, 20a | gate abnormality detection unit |
| 21 | timing circuit |
| 22 | delay circuit |
| 23 | AND circuit |
| 24 | latch circuit |
| 25 | abnormality determination circuit |
| 26 | open/short-circuit detection determination circuit |

| 30 | motor |
|---|---|
| S1 to S6 | IGBT |
| V1, V2 | direct-current power supply |
| CMP1, CMP2 | comparator |
| Ic | constant current supply |
| Vcc | power supply |

**Claims**

1. A gate drive circuit including a drive unit connected to a gate of a switching element and configured to drive the switching element, **characterized by**:

   an abnormality detection unit configured to supply a constant current to a control terminal of the switching element, and to detect an abnormality of the switching element based on a transient change in voltage at the control terminal of the switching element.

2. The gate drive circuit according to claim 1, wherein the abnormality detection unit determines whether the control terminal of the switching element is normal or abnormal based on a change in voltage at the control terminal of the switching element.

3. The gate drive circuit according to claim 1 or 2, wherein the abnormality detection unit comprises:

   a constant current circuit configured to supply a constant current to the control terminal of the switching element; and
   a determination circuit configured to determine the abnormality of the switching element based on the transient change in voltage at the control terminal of the switching element, after a lapse of a prescribed period from a point when the constant current circuit supplies the constant current to the control terminal of the switching element.

4. The gate drive circuit according to any one of claims 1 to 3, wherein a current value of the constant current is smaller than a value of a current to be supplied to the control terminal before driving the switching element.

5. The gate drive circuit according to any one of claims 1 to 4, wherein the constant current is supplied to the control terminal in an off period of the switching element.

6. The gate drive circuit according to any one of claims 1 to 5, wherein the constant current is supplied to the control terminal over a period shorter than an off period of the switching element.

7. The gate drive circuit according to claim 3, wherein the determination circuit determines whether the switching element is open or short-circuited based on the transient change in voltage at the control terminal of the switching element, after the lapse of the prescribed period from the point when the constant current circuit supplies the constant current to the control terminal of the switching element.

8. An intelligent power module **characterized by**:

   the gate drive circuit according to any one of claims 1 to 7; and
   the switching element to be connected to the gate drive circuit.

FIG. 1

EP 3 076 549 A1

FIG. 2

EP 3 076 549 A1

# FIG. 3

FIG. 4

FIG. 5

**INTERNATIONAL SEARCH REPORT**

| International application No. |
| --- |
| PCT/JP2013/081774 |

**A. CLASSIFICATION OF SUBJECT MATTER**
*H03K17/00*(2006.01)i, *H03K17/687*(2006.01)i

According to International Patent Classification (IPC) or to both national classification and IPC

**B. FIELDS SEARCHED**

Minimum documentation searched (classification system followed by classification symbols)
H03K17/00-17/70

Documentation searched other than minimum documentation to the extent that such documents are included in the fields searched
　　　Jitsuyo Shinan Koho　　　　1922-1996　　Jitsuyo Shinan Toroku Koho　1996-2013
　　　Kokai Jitsuyo Shinan Koho　1971-2013　　Toroku Jitsuyo Shinan Koho　1994-2013

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2007-235245 A (Toyota Motor Corp.), 13 September 2007 (13.09.2007), paragraphs [0013] to [0015]; fig. 1 (Family: none) | 1-8 |
| Y | JP 2006-279866 A (Fujitsu Ten Ltd.), 12 October 2006 (12.10.2006), paragraphs [0049], [0066] to [0074], [0085]; fig. 3 (Family: none) | 1-8 |

☐ Further documents are listed in the continuation of Box C.　　☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 　16 December, 2013 (16.12.13) | 　24 December, 2013 (24.12.13) |

| Name and mailing address of the ISA/ 　Japanese Patent Office | Authorized officer |
| --- | --- |
| Facsimile No. | Telephone No. |

Form PCT/ISA/210 (second sheet) (July 2009)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI279621 B

- JP HEI7298602 B